# EUROPEAN PATENT APPLICATION

(11) **EP 0 574 253 A2**
(43) Date of publication of application: **15.12.1993**
(21) Application number: 93304492.7
(22) Date of filing: 10.06.1993
(51) Int. Cl.: G01R 31/00, G06F 15/20

(54) **A diagnostic procedure**

(30) Priority: 10.06.1992 GB 9212310
(71) Applicant: THE AUTOMOBILE ASSOCIATION LIMITED, Basingstoke, Hampshire RG21 2EA (GB)
(72) Inventor: Russell, Stephen, Scalford Leicestershire LE14 4DW (GB)
(74) Representative: Tregear, George Herbert Benjamin

(57) **Abstract**

A method of, and a handheld personal computer for, diagnosis and/or repair of an electrical or electronic apparatus which includes a number of electrical, electronic and/or electro-mechanical components, the method comprising the steps of measuring an initial electrical value from a specified part of the apparatus or of a specified component; inputting the initial electrical value into a handheld personal computer which is programmed according to a diagnostic algorithm and which responds to the input of the initial electrical value by directing the subsequent steps to be taken by the operator, the diagnostic algorithm being embodied in an EPROM compatible for use with the handheld personal computer, and the handheld personal computer being programmed according to a diagnostic algorithm specific to a particular type of apparatus and responsive to information input by the operator to instruct the operator either to measure an electrical value of a specified part of the apparatus or of a specified component and to input that information into the handheld personal computer or to replace one or more components, the diagnostic algorithm being embodied in a compatible EPROM.

## Description

This invention relates to a diagnostic and/or repair procedure and/or equipment of an electrical or electronic apparatus which includes a number of electrical, electronic and/or electromechanical components, such as, for example, an automobile electrical system.

Known methods of diagnosis and/or repair of such apparatus are either manual, where an operator follows a diagnostic or repair procedure which is printed in a reference document, or they are carried out by complicated automatic test equipment.

Manual methods require the operator to refer repeatedly to the printed document, and to take measurements as directed by the printed procedure. Such a method is prone to error, particularly where the apparatus is complex, due, for example, to the operator missing out a step of the procedure or turning to the wrong page or portion of the printed document. Furthermore, where there are a large number of different types of apparatus for the operator to test, there may be a correspondingly large number of reference documents which are difficult to transport and to store, and the operator must ensure that the correct document is selected according to the particular apparatus.

Known automatic test equipment generally comprises at least one measurement circuit for measuring an electrical value, a number of electrical leads which are connected to selected positions on the apparatus, an analogue-to-digital converter unit for converting the analogue measurements of electrical values measured to a digital signal and a central processor unit in which the diagnostic of repair algorithm is embodied and which is responsive to the digital signal either to direct further measurements to be taken by the equipment or to indicate that one or more components are faulty and require replacement or repair. Such equipment is complicated and expensive, and may only be capable of use with a particular type of apparatus. Furthermore, the operator has to connect all the electrical leads to the correct positions on the apparatus before the equipment can be operated. Such a step is a potential source of error, particularly where there is a large number of electrical leads to be connected.

A method of diagnosis and/or repair of an electrical or electronic apparatus, which includes a number of electrical, electronic and/or electromechanical components, in accordance with the invention comprises the steps of measuring an initial electrical value from a specified part of the apparatus or a specified component; inputting the initial electrical value into a handheld personal computer which is programmed according to a diagnostic algorithm and which responds to the input of the initial electrical value by directing the subsequent steps to be taken by the operator, the diagnostic algorithm being embodied in an EPROM compatible for use with the handheld personal computer.

With such a method, the electrical value may be measured using a conventional meter of the type having two electrical leads for connecting in parallel with, or in series with, a component or a part of the apparatus. By utilising the operator to input the electrical value into the handheld personal computer there is no need for an analogue-to-digital converter as used in known automatic test equipments; the operator, using the alpha-numeric keyboard common to such handheld personal computers, inputs the measured electrical value in a digital format which is readily recognised by the central processor unit of the handheld personal computer.

The method may comprise the steps of identifying the type of apparatus; selecting an EPROM, embodying a diagnostic algorithm specific to the type of apparatus, and loading the selected EPROM into the handheld personal computer. With such a procedure, an operator would be provided with a set of EPROM's each of which embody an algorithm relating specific 3to the diagnosis and/or repair of a particular type of apparatus such as a vehicle. Such a set of EPROM's may be both easier to use with a handheld personal computer, and the combination is considerably easier both to store and to transport than reference manuals or automatic test equipment.

Alternatively, information as to the type of apparatus to be tested may be inputted into an appropriately programmed handheld personal computer which responds by instructing the operator where and how to take the initial electrical measurement.

With such an arrangement, the operator may be given explicit instructions of how to initiate the diagnostic procedure. This is particularly advantageous where the operator is unfamiliar with the particular type of apparatus, or where the operator is inexperienced.

The subsequent steps may comprise measuring a further electrical value from another part of the apparatus or of another component as instructed by the handheld personal computer, and inputting the further electrical value into the handheld personal computer which responds by directing the subsequent steps to be taken by the operator. Further instructions may be given to take yet further measurements, or the subsequent steps may comprise the iteration of the previous steps.

With such a procedure, the operator may be given step-by-step instructions in order to correctly diagnose and/or repair an apparatus, without requiring complex, expensive equipment, and the apparatus may be programmed so as to provide more detailed instructions for the less experienced operator, or suitable directions so as to instruct the novice or apprentice operator.

## Claims

1. A method of diagnosis and/or repair of an electrical or electronic apparatus which includes a number of electrical, electronic and/or electro-mechanical components, the method comprising the steps of measuring an initial electrical value from a specified part of the apparatus or of a specified component; inputting the initial electrical value into a handheld personal computer which is programmed according to a diagnostic algorithm and which responds to the input of the initial electrical value by directing the subsequent steps to be taken by the operator, the diagnostic algorithm being embodied in an EPROM compatible for use with the handheld personal computer.

2. The method as claimed in Claim 1 comprising the steps of identifying the type of apparatus and inputting that information into the handheld personal computer which responds by instructing the operator where and how to take the initial electrical measurement.

3. The method as claimed in Claim 1 or 2 wherein the subsequent steps comprise measuring a further electrical value from another part of the apparatus or of another component as instructed by the handheld personal computer and inputting the further electrical value into the handheld personal computer which responds by directing the subsequent steps to be taken by the operator.

4. The method as claimed in Claim 1, 2 or 3 wherein the subsequent steps comprise the iteration of the steps as claimed in Claim 3.

5. The method as claimed in any preceding Claim wherein the subsequent steps comprise the removal of at least one component identified by the handheld personal computer and the replacement of the or each component by a new or replacement component.

6. The method as claimed in any preceding Claim comprising identifying the type of apparatus; selecting an EPROM embodying a diagnostic algorithm specific to the type of apparatus, and loading the selected EPROM into the handheld personal computer.

7. A handheld personal computer for the diagnosis and/or repair of an electrical or electronic apparatus which includes a number of electrical, electronic, and/or electromechanical components, the handheld personal computer being programmed according to a diagnostic algorithm specific to a particular type of apparatus and responsive to information input by the operator to instruct the operator either to measure an electrical value of a specified part of the apparatus or of a specified component and to input that information into the handheld personal computer or to replace one or more components, the diagnostic algorithm being embodied in a compatible EPROM.

8. A handheld personal computer as claimed in Claim 7 in combination with a number of EPROM's wherein each EPROM embodies a diagnostic algorithm relating to a specific type of apparatus.
